# EUROPÄISCHE PATENTSCHRIFT

(11) **EP 3 194 635 B1**
(45) Veröffentlichungstag und Bekanntmachung des Hinweises auf die Patenterteilung: **20.11.2019**
(21) Anmeldenummer: 15766142.2
(22) Anmeldetag: 17.09.2015
(51) Int. Cl.: C23C 14/24, C23C 14/16, C23C 14/22, C23C 14/56, C23C 14/54

(54) **VORRICHTUNG ZUR AUSBILDUNG VON BESCHICHTUNGEN AUF OBERFLÄCHEN EINES BAUTEILS, BANDFÖRMIGEN MATERIALS ODER WERKZEUGS**
DEVICE FOR FORMING COATINGS ON SURFACES OF A COMPONENT, BAND-SHAPED MATERIAL OR TOOL
DISPOSITIF DE FORMATION DE REVÊTEMENTS DE SURFACES D'UN ÉLÉMENT, D'UN MATÉRIAU EN FORME DE BANDE OU D'UN OUTIL

(30) Priorität: 18.09.2014 DE 102014218770
(43) Veröffentlichungstag der Anmeldung: 26.07.2017
(73) Patentinhaber: ThyssenKrupp Steel Europe AG, 47166 Duisburg (DE)
(72) Erfinder: TOPALSKI, Slavcho, 44193 Dortmund (DE); STUCKY, Thomas, 44139 Dortmund (DE); ZWICK, Axel, 58119 Hagen (DE); KRATZENBERG, Klaus, 44536 Lünen (DE)
(74) Vertreter: Pfenning, Meinig & Partner mbB
(86) Internationale Anmeldenummer: PCT/EP2015/071327
(87) Internationale Veröffentlichungsnummer: WO 2016/042079

(56) Entgegenhaltungen:
- DE-A1-102011 002 183
- GB-A- 972 183
- US-A- 3 447 951
- US-A1- 2003 113 481
- US-A1- 2004 065 170
- US-A1- 2012 018 407
- US-A1- 2013 217 164
- US-B1- 6 210 755

## Beschreibung

Die Erfindung betrifft eine Vorrichtung zur Ausbildung von Beschichtungen auf Oberflächen eines Bauteils, bandförmigen Materials oder Werkzeugs sowie ein Verfahren mit einer solchen Vorrichtung. Dabei können unterschiedliche Beschichtungen, die insbesondere hochtemperaturbeständig, eine Verschleiß- oder Korrosionsschutzschicht bildende Beschichtungen ausgebildet werden.

Für die kontinuierliche Beschichtung von großen Flächen, z.B. schnell laufenden Stahlbandmaterialien, gibt es bis heute kein gut steuerbares Beschichtungsverfahren mit kontinuierlicher Materialzufuhr, bei dem die Beschichtung mittels Verdampfung erfolgt, das wirtschaftlich mit konventionellen Beschichtungsverfahren konkurrieren und mit dem auch Beschichtungen aus hochschmelzende Materialien ausgebildet werden können.

So erfolgt bisher die Beschichtung mit Bedampfungsverfahren, die bei Unterdruck arbeiten, wie dies z.B. bekannte Chemical Vapour Deposition Verfahren (CVD) und Physical Vapour Deposition Verfahren (PVD) sind, seit Jahrzehnten im Batchverfahren zur Veredelung von Bauteilen und Werkzeugen mit hochfunktionalen Schichten (Verschleißschutz, optische und magnetische Anwendungen, Mikroelektronik). Während sich CVD-Verfahren aufgrund des schwierigen Handlings der Precursoren und der Abgasnachbehandlung bisher nicht für kontinuierliche Prozesse durchgesetzt haben, sind PVD-Verfahren heute in vielen Bereichen zur Veredelung von Flachprodukten (Spiegel, Architekturglas) und Bahnen- und Rollenware (Verpackungsfolien, Kupfer- und Aluminiumband) unverzichtbar.

Der entscheidende Vorteil von PVD-Verfahren, bei denen das Beschichtungsmaterial durch physikalische Verfahren in den Dampfzustand versetzt wird, ist ihre sehr hohe Flexibilität bezüglich Schichtzusammensetzung und -struktur, was beispielsweise ein gezieltes Schichtdesign ermöglicht. Daher gibt es bereits seit den neunzehnhundertachtziger Jahren Bestrebungen und auch entsprechende Patente, z.B. Elektroband in einem kontinuierlichen Prozess mit Titannitrid zu beschichten, um die Ummagnetisierungsverluste zu senken.

Typischerweise kommen beim Bedampfen mit höherschmelzenden Metallen, wie z.B. Titan, als Verdampfungsquelle Tiegel, die mit festem oder flüssigem Metall gefüllt sind und die mit einer Elektronenstahlkanone verdampft werden, zum Einsatz. Problematisch ist hierbei die kontinuierliche Materialzufuhr in den Tiegel. Oberhalb des Tiegels kann aufgrund der Zugänglichkeitsproblematik für den Elektronenstrahl das Material nicht durch heiße Kanäle verlustarm zur zu beschichtenden Oberfläche des jeweiligen Bauteils oder Werkzeugs geleitet werden. Es verbleiben daher Streubeschichtungen, die nach kurzer Zeit gereinigt und einem Recyclingprozess zugeführt werden müssen, was einen hohen Aufwand hervorruft und zu Verlustzeiten führt, die nicht produktiv genutzt werden können.

Auch auf dem Gebiet der Erzeugung von Korrosionsschutzschichten aus Zink-Magnesium-Legierungen mittels PVD-Prozessen existieren bereits mehrere technische etablierte Lösungen. So wird die Herstellung durch Co-Verdampfung von Zn und Mg oder durch Aufdampfen von Schichtsystemen, die aus mehreren aufeinander folgenden Schichten aus abwechselnd Zn und Mg bestehen durchgeführt. Es wurde auch vorgeschlagen eine sich daran anschließende zusätzliche thermische Nachbehandlung durchzuführen.

Es ist auch bekannt mit PVD-Beschichtungsverfahren auf Zink- und Zinklegierungsüberzüge auszubilden. Dabei kann ein System, das aus zwei Jet-Verdampfern und einer Mischkammer besteht, eingesetzt werden. Dabei werden die Metalle in den Verdampfern induktiv erhitzt, der gebildete Metalldampf wird in eine Mischkammer und von da auf die Oberfläche eines laufenden bandförmigen Bauteils gerichtet. Dieses Verfahren erlaubt zwar hohe Raten, ist aber aufgrund der großen Mengen an schmelzflüssigem Material thermisch extrem träge, was die Regelung eines industriellen Prozesses sehr erschwert. Zudem müssen alle dampfberührten Oberflächen über der Kondensationstemperatur der eingesetzten Metalle gehalten werden, was insbesondere bei höher schmelzenden Metallen kaum zu beherrschen ist. Darüber hinaus ist die Herstellung von Metalllegierungsschichten mit definierter Zusammensetzung aus prozesstechnischen Gründen schwierig. Auch hier stellt sich das Problem einer kontinuierlichen Zufuhr der Materialien in die Verdampfer. So gibt es z.B. keine Materialien, die über längere Zeit flüssigem Magnesium standhalten.

Ein weiteres Verfahren basiert auf der elektromagnetischen Levitation. Dabei wird Drahtmaterial seitlich in ein Quarzröhrchen zugeführt und von einer Spule, die das Quarzröhrchen umgibt, erschmolzen, in der Schwebe gehalten und verdampft. Dieses Verfahren wurde an niedrig schmelzenden Metallen erfolgreich erprobt, bei bei höheren Temperaturen schmelzenden Metallen kann die Schicht jedoch nicht gleichmäßig auf einer Oberfläche abgeschieden werden. Zudem werden Droplets (größere Partikel) in die auf der jeweiligen Oberfläche ausgebildete Schicht inkorporiert, was für Korrosionsschutz-, Verschleißschutzschichten und Gleitverschleiß ausgesetzten Schichten nicht akzeptabel ist.

Verfahren, bei denen abgehackte metallische Drahtstücke auf eine überhitze Platte aufgebracht werden und dort sofort verdampfen, sogenannte Flashverdampfer, lösen zwar das Materialzuführungsproblem. Aufgrund der Materialzufuhr in fester Phase und der Notwendigkeit von Temperaturen deutlich oberhalb der Verdampfungstemperatur an jedem Drahtstückchen wird jedoch keine ausreichende Verdampfungsrate erzielt.

Beim ebenfalls etablierten thermischen Spritzen - insbesondere in der Verfahrensvariante des Lichtbogendrahtspritzens - ist ein preisgünstiges und flexibles Verfahren zur Stückverzinkung von Bauteilen bekannt. Dabei wird zwischen einem anodisch und einem kathodisch geschalteten Draht oder solchen Elektroden ein elektrischer Lichtbogen unterhalten, der das Material an den Drahtenden zu einem kleineren Teil verdampft und zu einem größeren Teil verflüssigt. Ein Gasstrahl reißt das flüssige Material von den Drahtenden ab und beschleunigt es auf die zu beschichtende Oberfläche zu. Da die schmelzflüssigen Tröpfchen sehr klein sind, erstarren sie beim Auftreffen auf die kalte Substratoberfläche sehr schnell und bilden eine lamellenartige Struktur aus, die im Vergleich mit den bisher beschriebenen Verfahren recht porös ist. Um eine ausreichende Korrosionsschutzwirkung zu erzielen, müssen daher Schichten mit Dicken zwischen 70 µm und 150 µm abgeschieden werden. Die benötigten Schichtdicken sind damit um einen Faktor 10 bis 20 höher, als bei den typischerweise bei Bandverfahren eingesetzten Verfahren, so dass das thermische Spritzen allein aus Gründen der Ressourceneffizienz nicht für die Bandbeschichtung oder großen Oberflächen in Frage kommt. Hinzu kommt, dass durch thermisches Spritzen erzeugte Oberflächen im Allgemeinen zu rau für automobile Anwendungen sind und daher eine Nachbearbeitung erforderlich wäre. Außerdem bereitet die mangelnde Haftung bei vielen Materialpaarungen ein Problem.

So ist in US 2004/0065170 A1 ein Verfahren zur Herstellung eines nanostrukturierten Materials beschrieben.

US 2012/0018407 A1 betrifft ein System zum thermischen Spritzen.

Ein Verfahren und eine Verdampfungskammer zur Ausbildung eines kontinuierlichen Dampfstromes sind in US 6,210,755 B1 beschrieben.

Die Offenbarung von US 2013/0217164 A1 betrifft eine Vorrichtung zur Ausbildung organischer Schichten und in der US2003/0113481 A1 wird die Beschichtung von z.B. Solarzellen beschrieben.

Der Erfindung liegt die Aufgabe zugrunde, Möglichkeiten mit großen Beschichtungsraten, bei einem gut Steuer- und/oder regelbaren Beschichtungsverfahren durch Bedampfung von zu beschichtenden Oberflächen, mit kontinuierlicher Materialzufuhr, insbesondere auch für hochschmelzende Materialien oder Legierungssysteme, wie z.B. Eisen-Magnesium-Zink, zur Verfügung zu stellen.

Erfindungsgemäß wird diese Aufgabe mit einer Vorrichtung, die die Merkmale des Anspruchs 1 aufweist, gelöst. Anspruch 15 definiert ein Verfahren, bei dem mit einer Vorrichtung eine Beschichtung erreicht werden soll. Vorteilhafte Ausgestaltungen und Weiterbildungen der Erfindung können mit in untergeordneten Ansprüchen bezeichneten Merkmalen realisiert werden.

Bei der erfindungsgemäßen Vorrichtung ist mindestens ein zur Ausbildung der jeweiligen Beschichtung eingesetztes draht- oder bandförmiges Material in den Einflussbereich eines elektrischen Lichtbogens, der zwischen zwei draht- oder bandförmigen Elementen oder einer Kathode und einer Anode, die an eine elektrische Gleichspannungsquelle angeschlossen sind, ausgebildet ist, zuführbar. Der Lichtbogen kann dabei zwischen draht- oder bandförmigen Elementen, die mit dem/den Material(ein), die zur Ausbildung der Beschichtung genutzt werden, gebildet sind, ausgebildet sein.

Diese Einheit kann dabei vergleichbar einem Spritzkopf ausgeführt sein. Das mittels der Energie des Lichtbogens geschmolzene und/oder verdampfte Material strömt mittels eines Gasstromes eines Gases oder Gasgemisches in das Innere einer auf eine Temperatur, die mindestens der Verdampfungstemperatur des mindestens einen zur Beschichtung eingesetzten Materials oder des Materials mit der jeweils höchsten Verdampfungstemperatur entspricht, erwärmbaren Kammer durch einen Einlass ein. Dabei verdampft/verdampfen das/die Material(ien) in der Kammer vollständig und tritt/treten durch eine an der Kammer vorhandene Öffnung aus. Das/die verdampfte Material(ien) trifft/treffen auf die zu beschichtende Oberfläche des Bauteils, bandförmigen Materials oder Werkstücks zur Ausbildung der jeweiligen Beschichtung auf.

Da auf der Oberfläche des Bauteils, des bandförmigen Materials oder Werkzeugs eine weitaus niedrigere Temperatur herrscht geht das auftreffende Material in den festen Aggregatzustand über. Werden mehrere Materialien so eingesetzt kann eine in situ Legierungsbildung erfolgen, was insbesondere bei Metallen vorteilhaft möglich ist, mit denen mit anderen Verfahren keine oder nur eine sehr schwer durchführbare Legierungsbildung möglich ist.

Die Atmosphäre innerhalb der Kammer sollte sauerstofffrei sein, wenn keine ein Oxid enthaltende Beschichtung angestrebt wird. Zur Sicherstellung der Sauerstofffreiheit und zur Absenkung der Verdampfungstemperatur, des zugeführten Materials sollte der Druck innerhalb der Kammer gegenüber dem Umgebungsdruck, bevorzugt bis auf einen Druck, der minimal dem Druck entspricht, bei dem Wasser verdampft, abgesenkt sein. Dadurch kann eine gegen Stäube unempfindliche, preisgünstige Wasserringpumpe eingesetzt werden.

Die Materialzufuhr mit einem oder mehreren Draht/Drähten oder Band/Bändern des/der zu beschichtenden Materials/Materialien kann vorteilhaft über steuerbare Antriebsrollen erfolgen. Das Material kann dabei unter Umgebungsbedingungen gelagert und dann bevorzugt per kontinuierlicher Schleusentechnik zu dem unter Vakuumbedingen oder in einer sauerstofffreien Atmosphäre stattfindenden Lichtbogenschmelz- bzw. Verdampfungsprozess zugeführt werden.

Es können hierbei unterschiedliche draht- oder bandförmige Materialien in Dicke und Zusammensetzung inkl. Fülldrähte eingesetzt werden. Dadurch können homogene Legierungsschichtsysteme mit fast beliebiger Materialzusammensetzung auf Oberflächen von Bauteilen, bandförmigen Materialien oder Werkzeugen ausgebildet werden. Die Menge und die Anzahl der verwendeten Legierungen können dabei durch mehrere Lichtbögen mit Gasstromzufuhr und Zufuhr draht- oder bandförmigen Materials, die in eine Kammer eingebracht werden, praktisch beliebig erweitert werden. Durch Zusammenschweißen von draht- oder bandförmigem Material unter Atmosphärenbedingungen zu einem quasi Endlosdraht, kann ein ununterbrochener Betrieb auch über Wochen sichergestellt werden.

Das draht- oder bandförmige für die Ausbildung der Beschichtung eingesetzte Material kann durch einen elektrischen Lichtbogen, der zwischen Draht- oder Bandmaterial und einer wassergekühlten Kathode oder Anode ausgebildet wird, aufgeschmolzen bzw. teilweise verdampft werden. Das/die drahtförmige Material(ien) sollte(n) dabei vorteilhaft in einem flachen (spitzen) Winkel, vergleichbar einem Lichtbogendrahtspritzkopf, zueinander bzw. in Bezug zu einer Anode oder Kathode zugeführt werden. Der Winkel sollte bevorzugt im Bereich von 30° liegen. Es kann aber auch ein Lichtbogen zwischen mindestens zwei draht- oder bandförmigen Materialien ausgebildet ist, zum Schmelzen und/oder verdampfen des draht- oder bandförmigen Materials ausgebildet sein. Die draht- oder bandförmigen Materialien bilden dann die Kathode und Anode, die an eine elektrische Gleichspannungsquelle angeschlossen sind.

Eine Lichtbogenausbildung kann aber auch zwischen einem draht- oder bandförmigen Material, das an eine Elektrode einer elektrischen Gleichspannungsquelle angeschlossen ist und einer Kathode oder eine Anode, deren Material durch den Lichtbogen nicht abgeschmolzen oder gar verdampft wird, ausgebildet werden. Das an die eine Elektrode der elektrischen Gleichspannungsquelle angeschlossene draht- oder bandförmige Material bildet so eine Anode oder Kathode und die komplementäre Elektrode, also Kathode oder Anode ist mit einem nicht abschmelzenden Material gebildet.

Gleichzeitig kann ein bevorzugt sauerstofffreier Gasstrom (bevorzugt Stickstoff oder. Argon) in Längsrichtung an den Enden des draht- oder bandförmigen Materials oder der draht- oder bandförmigen Materialien, die im Einflussbereich des elektrischen Lichtbogens angeordnet sind, vorbeigeführt werden. Der Gasstrom reißt von den stirnseitigen Enden des Materials kleinste Schmelztröpfchen ab und treibt diese und den entstehenden Materialdampf durch eine düsenförmige Öffnung heraus und durch einen Einlass in das Innere der Kammer.

Das mittels des Lichtbogens zu verdampfende draht- oder bandförmige Material oder die zu verdampfenden Materialien (z.B. Fe, Zn, AI, Mg oder Legierungen damit) kann in Form von Drähten mit einem Durchmesser oder einer breite eines Bandes im Bereich weniger Millimeter vorliegen. Ein draht- oder bandförmiges Material kann mit der Anode, der andere mit der Kathode einer elektrischen Gleichstromquelle verbunden sein, die in der Lage ist, bei einer elektrischen Spannung zwischen 10 V und 80 V elektrische Ströme zwischen 20 A und 200 A zu liefern. Die jeweils gewählten elektrischen Spannungen und Ströme hängen von den zu verdampfenden Materialien ab. Für Fe können z.B. werden U = 30 V und I = 80 A gewählt werden. Die Kontaktierung ist vorteilhaft aus gut leitendem Material (Kupfer) in Form durchbohrten Stabmaterials ausgeführt, so dass drahtförmiges Material durch die Bohrung geführt werden kann. Dies erlaubt eine gute elektrische Kontaktierung und die Führung des drahtförmigen Materials dergestalt, dass sie sich mit ihren Enden treffen. Bei bandförmigem Material kann ein Schlitz anstelle einer Bohrung genutzt werden.

Wird eine elektrische Spannung angelegt, zündet ein elektrischer Lichtbogen zwischen den Enden der draht- oder bandförmigen Materialien, wenn sie an die Anode und eine Kathode einer elektrischen Gleichspannungsquelle angeschlossen sind. Draht- oder bandförmiges Material wird dadurch zumindest teilweise aufgeschmolzen und kann teilweise verdampfen. Zur Aufrechterhaltung des Lichtbogens muss daher drahtförmiges oder bandförmiges Material nachgeführt werden, was mit einer Zufuhreinrichtung erreichbar ist. Das draht- oder bandförmige Material und die sie umgebende elektrische Kontaktierung können vorteilhaft in einem Block aus temperaturbeständiger und elektrisch isolierender Keramik gehalten werden. Um das teils geschmolzene, teils verdampfte Material vollständig zu verdampfen, wird es durch einen Strom eines Gases, mit dem das zu verdampfende Material nicht reagiert, z.B. Argon, vorwärts in Richtung einer Kammer gerissen und in oder durch eine Heizeinrichtung befördert. Vorteilhaft wird der Keramikblock durch ein Rohr mit der Heizeinrichtung verbunden, um Gas, geschmolzenes und verdampftes Material verlustfrei in die Heizeinrichtung zu fördern.

Die Heizeinrichtung kann vorteilhaft aus hochtemperaturbeständigem, elektrisch leitendem Material, besonders vorteilhaft Graphit bestehen, und kann eine zylindrische Form aufweisen(Tiegel/Kammer). Das Verbindungsrohr zum Keramikblock sollte so angebracht sein, dass das Material tangential zugeführt werden kann, so dass es nach der Zufuhr im Tiegel in Form einer Zirkularströmung kreist. Die noch nicht verdampften, geschmolzenen Materialpartikel besitzen eine höhere Dichte als das gasförmige verdampfte Material. Die Materialpartikel können durch die Zirkularströmung nach außen an die innere Tiegelwand gedrängt werden, an der entlang sie kreisen und dabei die zum vollständigen Verdampfen benötigte Energie aus dem Wärmevorrat des Tiegels aufnehmen. Am Tiegel kann einen Deckel vorhanden sein, in dessen Mitte ein Rundrohr eingelassen ist, das axial in das Tiegelinnere eintaucht (Tauchrohr) und beidseits offen ist. Durch dieses Rohr können die bereits dampfförmigen Anteile des Materials den Tiegel nach oben verlassen.

Über der oberen Öffnung des Rohres werden vorteilhaft die zu beschichtenden Oberflächen angeordnet, dabei kann es sich z.B. um Bandmaterial handeln, das kontinuierlich über die Öffnung bewegt wird. Um die Reichweite des Dampfes zu erhöhen und eine Rekondensation des Materials zu vermeiden, kann die beschriebene Vorrichtung vorteilhaft in einer Kammer betrieben werden, in der Unterdruck herrscht.

Der Tiegel kann prinzipiell auf unterschiedlichste Weise beheizt werden. Vorteilhaft ist eine induktive Heizung. Dafür kann der Tiegel mit einem Induktor umgeben sein, der eine angepasste Impedanz besitzt und vorteilhaft im Bereich einiger kHz betrieben werden kann. Der Induktor ist vorteilhaft vollständig von einem Material umgeben, das die thermische und elektrische Isolation des Induktors sicherstellt. Dies kann z.B. Beton sein. Der Tiegel sollte zur Vermeidung von Wärmeverlusten durch Wärmestrahlung von thermisch isolierendem Material umgeben sein. Die Tiegeltemperatur muss so gewählt werden, dass die Siedetemperatur des zu verdampfenden Materials überschritten wird. Dies sind z.B. 1.200 °C für Zn, oder das zu verdampfende Material beim herrschenden Unterdruck bereits einen merklichen Dampfdruck besitzt (z.B. 2.600 °C für Fe).

Zur Erhöhung der Verdampfungsrate und/oder zum Verdampfen verschiedener Materialien kann der Tiegel vorteilhaft mit mehreren der oben beschriebenen Einrichtungen zur Zufuhr geschmolzenen und verdampften Materials ausgerüstet werden.

Zur Ausbildung des elektrischen Lichtbogens können, die beim Lichtbogendrahtspritzen bekannten elektrischen Stromquellen mit hoher Abschmelzleistung eingesetzt werden. Es können unterschiedliche elektrische Lichtbogenarten, je nach eingesetzten Material(ien), eingesetzt werden. Anzustreben ist im Gegensatz zu üblichen Spritzprozessen eine möglichst hohe Verdampfungsrate des zu verdampfenden Materials. Dies sollte auch durch eine Minimierung des Volumenstroms, der beim Zuführen des Gasstroms gewählt wird, unterstützt werden. Das Gas oder Gasgemisch, mit dem der Gasstrom gebildet wird, sollte hierbei zur Minimierung der Gasmenge und der notwendigen Energien im nachfolgenden Verdampfungsprozess innerhalb der Kammer vorteilhaft vorgewärmt zugeführt werden. Dies kann z.B. durch eine Leitungsspirale im Erwärmungsbereich des Induktors erfolgen. Der Gasstrom kann so durch den Einflussbereich des Induktors strömen und dabei erwärmt werden.

Das Gemisch aus Gasstrom, verdampftem Material und feinsten Schmelztröpfchen wird in die erwärmte Kammer eingebracht. Die Temperatur innerhalb der Kammer muss dabei mindestens der Verdampfungstemperatur des verdampften zur Ausbildung der Beschichtung eingesetzten Materials mit der jeweils höchsten Verdampfungstemperatur entsprechen, so dass die noch verbliebenen kleinen Schmelztröpfchen des Materials vollständig innerhalb der Kammer verdampft werden können. Die Verdampfungstemperatur und damit auch die jeweils erforderliche Kammertemperatur können durch Einsatz eines Unterdrucks deutlich gesenkt werden. Dies ist bei einigen hochschmelzenden Materialien notwendig und vorteilhaft, da ansonsten keine geeigneten Kammerwandwerkstoffe zur Verfügung stehen. Vorteilhaft ist ein Unterdruck, der minimal dem Druck entspricht, bei dem Wasser verdampft, um noch kostengünstige und gegen Stäube resistente Wasserringpumpen zur Vakuumerzeugung einsetzen zu können.

An der Kammer kann mindestens ein Spritzkopf vorhanden oder mindestens ein Spritzkopf kann auch mit der Kammer verbunden sein. Dabei sollte der Spritzkopf die Elemente aufweisen, die zur Ausbildung eines Lichtbogens und Gasstroms erforderlich sind. Die Elemente für die Zuführung von draht- oder bandförmigem Material können ebenfalls Bestandteil eines Spritzkopfes sein.

Ein Spritzkopf kann dabei so angeordnet sein, dass die Düse des Spritzkopfes sich in der Kammer befindet oder zwischen Spritzkopf und Kammerwand kann ein Injektorrohr angeordnet sein. Natürlich können auch mehrere Spritzköpfe an einer Kammer angeordnet sein.

Der durch die Düse des Spritzkopfes ausströmende Gas-Dampf-Tröpfchenstrom verhindert hierbei ein Eindringen von verdampftem Material in den Spritzkopf. Die Düse des Spritzkopfes sollte hierbei mindestens der Schmelztemperatur des höchstschmelzenden, zugeführten Materials entsprechen, um ein Zuwachsen der Düse zu verhindern. Anzustreben ist auch hier die Verdampfungstemperatur. Bevorzugt ist daher die Düse und der Spritzkopf und ggf. das Injektorrohr aus hochtemperaturbeständigem, isolierendem Keramikmaterial oder aus einer Mischung aus Graphitkomponenten und isolierendem Keramikmaterial anzufertigen. Dabei ist als keramischer Werkstoff Bornitrid zu bevorzugen. Zur elektrischen Kontaktierung der band- bzw. drahtförmigen Materialien sollten wassergekühlte Kontaktelemente, bevorzugt aus Kupfer in den Spritzkopf integriert werden. Durch eine Ausbildung der Öffnung in Form einer sich konisch verkleinernden oder vergrößerten Düse bzw. der Ausbildung der Kammer vor der Öffnung/Düse kann die mechanische Energie bzw. die geometrische Form des ausströmende Gas-Dampf-Tröpfchenstrom beeinflusst werden.

Als Werkstoff für die Kammerwandung sollte aufgrund seiner guten Temperaturbeständigkeit, Wärmeleitfähigkeit und elektrischen Leitfähigkeit bevorzugt Graphit eingesetzt werden. Es kann je nach zu verdampfendem Material(ien) mit hochtemperaturbeständigen, für Schmelze resistenten keramischen Werkstoffen, z.B. Bornitrid für die Ausbildung von Beschichtungen mit Eisen und Aluminium, bevorzugt in Form einer teilweisen oder kompletten Auskleidung kombiniert werden.

Die Kammer kann dabei bevorzugt durch eine Induktionsheizung auf bzw. oberhalb der Verdampfungstemperaturen aufgeheizt werden. Zur Isolation bei Temperaturen > 2000 °C ist hierbei eine Kombination aus Graphitwolle und aluminiumoxidummantelten, wassergekühlten Kupferinduktoren zu bevorzugen. Es kann aber auch eine Heizung über CFC-Wiederstandheizelemente im oder außerhalb der Kammer erfolgen.

Um die erforderliche Kammertemperatur zu minimieren und gleichzeitig einen Austritt von Schmelztröpfchen aus dem Inneren der Kammer zu verhindern bzw. sicherzustellen, dass die Schmelztröpfchen möglichst lange an den geheizten Außenwänden der Kammer verbleiben oder entlang strömen, kann die Wandung der Kammer Kanäle bilden, durch die das geschmolzene und/oder verdampfte Material über einen längeren Weg und einen verlängerten Zeitraum strömt. Die Kammerwandung wird erfindungsgemäss in der Form eines Zyklonabscheiders ausgeführt. Dabei sollte das zu beschichtende Material bevorzugt, wie auf einem Luftkissen, auf dem Gas- und/oder Dampfstrom gleiten und der gebildete Dampf innerhalb der Kammer so geführt werden, dass er sich vollständig auf der zu beschichtenden Oberfläche abscheiden kann. Dies kann durch eine geeignete Öffnungs- oder Düsenform, durch die das verdampfte Material aus der Kammer heraus geführt wird, vorteilhaft beeinflusst gestellt werden. In jedem Fall sollte ein direkter Kontakt zwischen Kammerwand und zu beschichtendem Material verhindert werden, da dies zu einer Beeinträchtigung der auszubildenden der Beschichtung und/oder zu einer Beschichtung der Kammerwand führen kann.

Ist keine vollständige Abscheidung des Dampfstroms als Beschichtung auf der jeweiligen Oberfläche eines Bauteils, bandförmigen Materials oder Werkzeugs im direkten Auftreffbereich des Dampfes möglich, kann das zum Beschichten eingesetzte Material in einem heißen Kanal oberhalb der Öffnung der Kammer geführt werden.

Die Legierungszusammensetzung der oberhalb der Öffnung der Kammer aufgedampften Beschichtung kann durch unterschiedliche Vorschubgeschwindigkeiten, mit denen draht- oder bandförmiges Material dem elektrischen Lichtbogen zugeführt wird, in Kombination mit geeigneten Lichtbogenparametern bzw. durch ein An- oder Abschalten beliebig und schnell gesteuert bzw. geregelt werden.

Dadurch kann die Menge des/der dampfförmigen für die Ausbildung der Beschichtung eingesetzten Materials/Materialien an die Vorschubgeschwindigkeit, mit der die zu beschichtende Oberfläche vorbei bewegt wird, angepasst werden.

Sollen größere Oberflächenbereiche oder bestimmte Oberflächenbereiche beschichtet werden, können mehrere Öffnungen an einer Kammer vorhanden sein, durch die verdampftes Material auf die zu beschichtende Oberfläche gerichtet werden kann. Es können auch mehrere Lichtbögen mit Zuführung für einen Gasstrom und draht- oder bandförmigen Material(ein) in einer Kammer vorhanden sein. Es können auch mehrere Kammern miteinander, z.B. durch eine längliche Druckkammer, verbunden werden.

Für bestimmte Schichtsysteme, mit denen eine Beschichtung auf einer Oberfläche eines Bauteils, bandförmiges Material oder Werkzeugs ausgebildet werden sollen, kann eine zusätzliche Ionisierung des austretenden Dampfes, wie sie aus dem Bereich der Elektronenstrahlverdampfer bekannt ist, eine Verbesserung der Schichteigenschaften bewirken.

Wird das Bauteil, bandförmiges Material oder Werkzeug ausreichend erwärmt und/oder der Dampf ionisiert und ggf. beschleunigt, so kann auch ein Einlegieren der aufgedampften Materialien erfolgen bzw. es erfolgt ein Legieren der Beschichtung durch das Grundmaterial.

Es besteht auch die vorteilhafte Möglichkeit, den Abstand des/der zu beschichtenden Oberfläche eines bandförmigen Materials zur Oberfläche der Kammer zumindest im Bereich der Öffnung mittels der kinetischen Energie des ausströmenden Dampf-Gasstroms einzustellen. Dadurch kann sich ein die Reibung erheblich reduzierendes Gaspolster ausbilden und dabei ein sehr kleiner Abstand eingehalten werden, wodurch ein Verlust an Beschichtungsmaterial verringert oder gar ganz vermieden werden kann.

Nachfolgend soll die Erfindung beispielhaft näher erläutert werden.

Dabei zeigt:

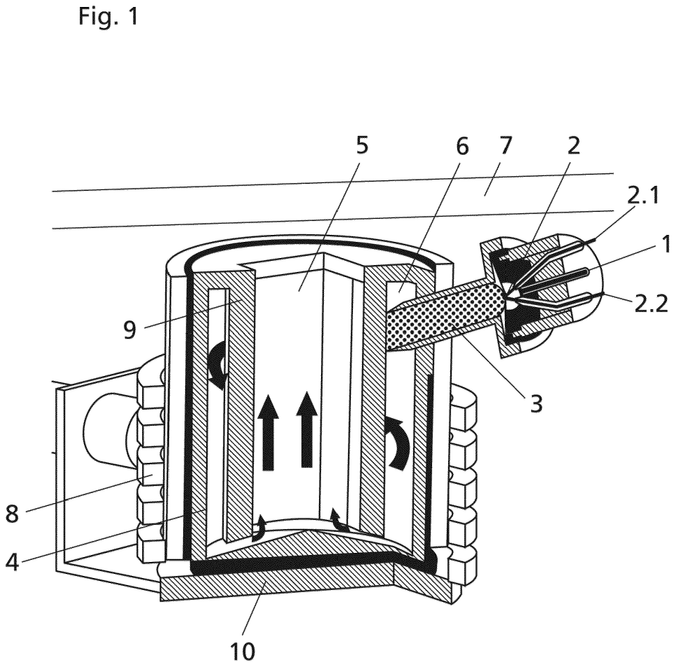

- Figur 1: ein Beispiel einer erfindungsgemäßen Vorrichtung zur Ausbildung einer Beschichtung auf einer Oberfläche eines Bauteils.

In Figur 1 ist eine Vorrichtung zur Ausbildung einer Beschichtung auf einer Oberfläche eines Bauteils 7, hier ein bandförmiges Material aus Stahl, gezeigt.

Dabei wird ein drahtförmiges Material 2.1 und 2.2 mit Hilfe von Antriebsrollen (nicht dargestellt) so zugeführt, dass sich zwischen diesen Drähten ein Lichtbogen 2 ausbilden kann, wenn man mittels einer elektrischen Gleichstromquelle einen Draht als Kathode 2.1 und einen Draht als Anode 2.2 ausbildet. Hierdurch werden die stirnseitigen Enden verdampft und/oder zumindest geschmolzen.

In diesen Bereich wird ein Gasstrom 1 eines bevorzugt auf eine Temperatur von mindestens 600 °C erwärmten Gases oder Gasgemisches, in dem kein Sauerstoff enthalten ist, mit einem Volumenstrom zugeführt, der ausreichend ist, das geschmolzene und/oder verdampfte Material 2.1 und 2.2 durch ein Injektorrohr 3 in die als Zyklon ausgeführte Kammer 4 einzubringen.

Das Gas-Dampf-Tröpfchengemisch wird so in die als Zyklon ausgebildete Kammer 4 eingebracht, dass sich eine rotatorische Strömung in mindestens einem Kanal 6 zwischen Kammerwand 4 und einem Tauchrohr 9 ausbildet. Hierdurch werden die vorhandenen Schmelztröpfchen an der geheizten Außenwand der Kammer 4 abgeschieden, dort verdampft und ein Gas-Dampfstrom wird zu einer Öffnung 5, die im Bereich des Tauchrohrs 9 angeordnet ist, befördert.

Dabei befindet sich die zu beschichtende Oberfläche des Bauteils 7 außerhalb der Kammer 4 in einem geringen Abstand zur Öffnung 5 und wird während der Ausbildung der Beschichtung translatorisch oder rotatorisch mit einer geeigneten Vorschubgeschwindigkeit bewegt, so dass die gesamte zur Beschichtung vorgesehene Oberfläche beschichtet werden kann.

Auf eine Darstelllung einer Zufuhreinrichtung für drahtförmiges Material, die beispielsweise mittels mindestens zweier Rollen, von denen mindestens eine antreibbar sein sollte, ist verzichtet worden.

Der/die Kanal/Kanäle 6 ist/sind so ausgebildet, dass der Weg vom elektrischen Lichtbogen 2 bis zur Öffnung 5 verlängert ist und Schmelztröpfchen durch eine rotatorische Strömung auf der geheizten Wandung verbleiben, um die Kontaktzeit des verdampften und/oder verdampften Materials mit der geheizten Wandung und die Verweilzeit in der Kammer 4 zu verlängern. Da die Wandung der Kammer 4 mittels einer die Kammer 4 von außen umschließenden Induktionsheizung 8 bis oberhalb der Verdampfungstemperatur des Materials 2.1 u. 2.2, mit dem die Beschichtung ausgebildet werden soll, bei dem jeweils in der Kammer 4 eingehaltenen Druck, erwärmt worden ist, gelingt es das zur Beschichtung eingesetzte Material 2.1 u. 2.2 vollständig zu verdampfen, bevor es aus der Öffnung 5 austritt und auf die zu beschichtende Oberfläche des Bauteils 7 auftrifft. Dadurch kann insbesondere eine Beschichtung der Wandung der Kammer 4 und eine zumindest nahezu vollständige Ausnutzung des für die Ausbildung der Beschichtung eingesetzten Materials erreicht werden. Bei vollständiger Verdampfung können auch austretende Tröpfchen (Droplets) vermieden werden, die sich in der Beschichtung einlagern und zur Verschlechterung der Oberflächengüte führen würden. Durch eine trichterförmige Ausbildung des Kammerbodens 10 kann ggf. sogar bei einer falschen Temperaturwahl ein Austritt von Schmelztröpfchen komplett vermieden werden.

Wie bereits zum Ausdruck gebracht, sollte der Druck im Inneren der Kammer 4 gegenüber dem Umgebungsdruck reduziert worden sein, um möglichst die maximal für die vollständige Verdampfung des Materials erforderliche Temperatur reduzieren zu können.

Die Wandung der Kammer 4 ist bei diesem Beispiel aus Graphit gebildet. Bei Materialien deren Schmelzen Graphit angreifen können zumindest Teile der Kammer 4 mit keramischen Werkstoffen, z.B. Bornitrid ausgekleidet sein. Hierdurch können auch solche Materialien für die Ausbildung von Beschichtungen eingesetzt werden, bei denen reines Graphit nicht einsetzbar ist.

## Patentansprüche

1. Vorrichtung zur Ausbildung von Beschichtungen auf Oberflächen eines Bauteils, bandförmigen Materials oder Werkzeugs, bei dem mindestens ein zur Ausbildung der jeweiligen Beschichtung eingesetztes draht- oder bandförmiges Material (2.1 und/oder 2.2) eine Kathode und/oder eine Anode /bildet/bilden, die an eine elektrische Gleichspannungsquelle angeschlossen sind, und zwischen denen ein elektrischer Lichtbogen ausgebildet ist, wobei draht- oder bandförmiges Material (2.1 und/oder 2.2) mittels einer Zufuhreinrichtung zuführbar ist; und
dabei geschmolzenes und/oder verdampftes Material des draht- oder bandförmigen Materials (2.1 und/oder 2.2) mittels eines Gasstromes (3) eines Gases oder Gasgemisches in das Innere einer auf eine Temperatur, die mindestens der Verdampfungstemperatur des mindestens einen zur Beschichtung eingesetzten Materials oder des Materials mit der jeweils höchsten Verdampfungstemperatur entspricht, erwärmbaren Kammer (4) durch einen Einlass einströmt, und
dabei das/die Material(ein) vollständig verdampft, und durch mindestens eine an der Kammer (4) vorhandene Öffnung (5) austritt und auf die zu beschichtende Oberfläche des Bauteils oder Werkstücks (6) zur Ausbildung der jeweiligen Beschichtung auftrifft;
**dadurch gekennzeichnet, dass**
die Kammer in Form eines Zyklonabscheiders ausgebildet ist.

2. Vorrichtung nach Anspruch 1, **dadurch gekennzeichnet, dass** die Atmosphäre in der Kammer und an der Öffnung (5), für den Fall, dass keine oxidhaltige Beschichtung ausgebildet werden soll, sauerstofffreigehalten ist.

3. Vorrichtung nach Anspruch 1 und 2, **dadurch gekennzeichnet dass** zur Absenkung der Verdampfungstemperatur und/oder zur Sicherstellung der Sauerstofffreiheit der Druck innerhalb der Kammer (4) gegenüber dem Umgebungsdruck, bevorzugt bis auf einen Druck, der minimal dem Druck entspricht, bei dem Wasser verdampft, absenkbar ist.

4. Vorrichtung nach einem der vorhergehenden Ansprüche, **dadurch gekennzeichnet, dass** die Kammer (4) mittels einer um die Kammer (4) herum ausgebildeten oder im Werkstoff der Kammerwand integrierten Induktionsheizung (8) erwärmbar ist.

5. Vorrichtung nach einem der vorhergehenden Ansprüche **dadurch gekennzeichnet, dass** das Gas oder Gasgemisch durch den Erwärmungsbereich eines Induktors zu seiner Erwärmung strömt.

6. Vorrichtung nach einem der vorgehenden Ansprüche **dadurch gekennzeichnet, dass** ein Spritzkopf aus hochtemperaturbeständigem Keramikwerkstoff, bevorzugt Bornitrid oder einer Mischung aus Bornitridkomponenten und Graphitkomponenten gefertigt ist und/oder Kontaktelemente für das/die band- und/oder drahtförmigen Material(ein) wassergekühlte Kupferelementen sind.

7. Vorrichtung nach einem der vorhergehenden Ansprüche, **dadurch gekennzeichnet, dass** Kanäle (6) mit der Wandung der Kammer (4) ausgebildet sind, durch die verdampftes und noch zu verdampfendes Material bis zum Austritt aus der Öffnung (5) mit einem verlängerten Weg innerhalb eines vergrößerten Zeitraumes hindurch führbar ist.

8. Vorrichtung nach einem der vorhergehenden Ansprüche, **dadurch gekennzeichnet, dass** zwei band- oder drahtförmige Materialien (2.1, 2.2), aus mit mindestens zwei unterschiedlichen Werkstoffen gebildet sind und/oder ein Fülldraht, ist/sind.

9. Vorrichtung nach einem der vorhergehenden Ansprüche, **dadurch gekennzeichnet, dass** die Kammerwandung aus Graphit oder Graphit in Kombination mit einem keramischen Werkstoff, insbesondere Bornitrid gebildet ist.

10. Vorrichtung nach einem der vorhergehenden Ansprüche, **dadurch gekennzeichnet, dass** mehrere Öffnungen (5) an einer Kammer (4) vorhanden sind.

11. Vorrichtung nach einem der vorhergehenden Ansprüche, **dadurch gekennzeichnet, dass** mehrere Lichtbögen (2) an Spritzköpfen in einer Kammer (4) ausgebildet sind und/oder mehrere Kammern (4) miteinander, insbesondere mittels einer länglichen Druckkammer, verbunden sind.

12. Vorrichtung nach einem der vorhergehenden Ansprüche, **dadurch gekennzeichnet, dass** die Öffnung(en) (5) der Kammer (4) und die Düse des Spritzkopfes mindestens die Schmelztemperatur des höchstschmelzenden Materials aufweist/aufweisen.

13. Vorrichtung nach einem der vorhergehenden Ansprüche, **dadurch gekennzeichnet, dass** zur Isolation der Kammer (4) bei Temperaturen > 2000 °C eine Kombination aus Graphitwolle für die Kammerwand und aluminiumoxidummantelten, wassergekühlten Kupferinduktoren für eine Induktionsheizung eingesetzt ist.

14. Vorrichtung nach einem der vorhergehenden Ansprüche, **dadurch gekennzeichnet, dass** eine Öffnung (5) in Form einer sich konisch verkleinernden oder vergrößerten Düse ausgebildet ist.

15. Verfahren zur Ausbildung von Beschichtungen auf Oberflächen eines Bauteils, bandförmigen Materials oder Werkzeugs mit einer Vorrichtung nach einem der vorhergehenden Ansprüche, **dadurch gekennzeichnet, dass** die Dicke und Zusammensetzung einer Beschichtung durch die Menge des zugeführten draht- oder bandförmigen Materials (2.1, 2.2), An- und Abschaltung von einem oder mehreren Lichtbögen (2) und/ oder Kammern oder
die Menge des verdampften Materials bezogen auf die Menge des abgeschmolzenen Materials beim Lichtbogenabschmelzprozess durch Beeinflussung des Volumenstroms des Gasstroms beeinflusst wird und/oder
der Abstand des/der zu beschichtenden Oberfläche eines bandförmigen Materials (7) zur Oberfläche der Kammer (4) zumindest im Bereich der Öffnung (5) mittels der kinetischen Energie des ausströmenden Dampf-Gasstroms eingestellt wird.

## Claims

1. A device for forming coatings on surfaces of a component, band-shaped material, or tool, in which at least one wire-shaped or band-shaped material (2.1 and/or 2.2) used for forming the respective coating forms a cathode and/or an anode that are connected to an electrical direct current voltage source and between which an electric arc is formed, wherein wire-shaped or band-shaped material (2.1 and/or 2.2) may be fed by means of a feed device; and
in the process melted and/or evaporated material of the wire-shaped or band-shaped material (2.1 and/or 2.2) flows, by means of a gas jet (3) of a gas or gas mixture, through an inlet into the interior of a chamber (4) that can be heated to a temperature that is at least equal to the evaporation temperature of the at least one material used for the coating or of the material with the respectively highest evaporation temperature, and
in the process the material(s) completely evaporate(s) and exits through at least one opening (5) present on the chamber (4) and impinges on the surface to be coated of the component or tool (6) for forming the respective coating;
**characterized in that**
the chamber is formed in the shape of a cyclone separator.

2. The device according to claim 1, **characterized in that** the atmosphere in the chamber and on the opening (5) is maintained oxygen-free in the case, where no coating containing oxide is to be formed.

3. The device according to claims 1 and 2, **characterized in that**, for reducing the evaporation temperature and/or ensuring freedom from oxygen, the pressure within the chamber (4) is lowerable compared to the ambient pressure, preferably to a pressure that corresponds at a minimum to the pressure at which water evaporates.

4. The device according to any of the preceding claims, **characterized in that** the chamber (4) may be heated by means of an inductive heating unit (8) formed around the chamber (4) or integrated in the material of the chamber wall.

5. The device according to any of the preceding claims, **characterized in that** the gas or gas mixture flows through the heating area of an inductor to heat it.

6. The device according to any of the preceding claims, **characterized in that** a spray head is fabricated from high temperature-resistant ceramic material, preferably boron nitride or a mixture of boron nitride components and graphite components and/or contact elements for the band-shaped and/or wire-shaped material(s) are water-cooled copper elements.

7. The device according to any of the preceding claims, **characterized in that** channels (6) are formed with the walls of the chamber (4), through which evaporated material and material still to be evaporated may be guided up to the exit from the opening (5) with an extended path within an extended period of time.

8. The device according to any of the preceding claims, **characterized in that** two band-shaped or wire-shaped materials (2.1, 2.2) is/are formed from at least two different materials and/or a flux-cored wire.

9. The device according to any of the preceding claims, **characterized in that** the chamber walls are formed from graphite or graphite combined with a ceramic material, especially boron nitride.

10. The device according to any of the preceding claims, **characterized in that** a plurality of openings (5) are present on a chamber (4).

11. The device according to any of the preceding claims, **characterized in that** a plurality of arcs (2) are embodied on spray heads in a chamber (4) and/or a plurality of chambers (4) are connected to one another, in particular by means of a longitudinal pressure chamber.

12. The device according to any of the preceding claims, **characterized in that** the opening(s) (5) of the chamber (4) and the nozzle of the spray head have/has at least the melting temperature of the material with the highest melting point.

13. The device according to any of the preceding claims, **characterized in that**, for insulating the chamber (4) at temperatures > 2000 °C, a combination of graphite wool for the chamber wall and aluminum oxide-covered, water-cooled copper inductors is used for an induction heating unit.

14. The device according to any of the preceding claims, **characterized in that** an opening (5) is embodied in the shape of a conically decreasing or enlarged nozzle.

15. A method for forming coatings on surfaces of a component, band-shaped material, or tool with a device of the preceding claims, **characterized in that** the thickness and composition of a coating is influenced by the quantity of the fed wire-shaped or band-shaped material (2.1, 2.2), the turning on and off of one or a plurality of arcs (2) and/or chambers or
the quantity of the material to be evaporated relative to the quantity of the molten material during the arc melting process through the influence of the volume flow of the gas jet and/or
the distance between the surface of a band-shaped material (7) to be coated and the surface of the chamber (4) is adjusted, at least in the area of the opening (5), by means of the kinetic energy of the outflowing vapor-gas stream.

## Revendications

1. Dispositif pour la formation de revêtements sur des surfaces d'un composant d'un matériau en forme de bande ou d'un outil, dans lequel au moins un matériau en forme de fil ou de bande (2.1 et/ou 2.2) utilisé pour la formation du revêtement forme une cathode et/ou une anode, qui sont raccordées à une source de courant continu, et entre lesquelles un arc électrique est formé, le matériau en forme de fil ou de bande (2.1 et/ou 2.2) pouvant être amené au moyen d'un dispositif d'alimentation ; et
le matériau fondu et/ou évaporé du matériau en forme de fil ou de bande (2.1 et/ou 2.2) est introduit, à travers une entrée, au moyen d'un flux de gaz (3) d'un gaz ou d'un mélange de gaz vers l'intérieur d'une chambre (4) pouvant être chauffée à une température, qui correspond au moins à la température d'évaporation de l'au moins un matériau utilisé pour le revêtement ou du matériau avec la température d'évaporation la plus élevée et
le ou les matériau(x) est/sont entièrement évaporé(s) et sort(ent), à travers au moins une ouverture (5) existant sur la chambre (4) et arrive sur la surface à revêtir du composant ou de la pièce (6) pour la formation du revêtement correspondant ;
**caractérisé en ce que**
la chambre présente la forme d'un séparateur cyclonique.

2. Dispositif selon la revendication 1, **caractérisé en ce que** l'atmosphère dans la chambre et au niveau de l'ouverture (5) est maintenue exempte d'oxygène dans le cas ou un revêtement sans oxydes doit être réalisé.

3. Dispositif selon la revendication 1 et 2, **caractérisé en ce que**, pour la réduction de la température d'évaporation et/ou pour garantir l'absence d'oxygène, la pression à l'intérieur de la chambre (4) par rapport à la pression ambiante, peut de préférence être baissée jusqu'à une pression qui correspond au minimum à la pression à laquelle l'eau s'évapore.

4. Dispositif selon l'une des revendications précédentes, **caractérisé en ce que** la chambre (4) peut être chauffée au moyen d'un chauffage à induction (8) enroulé autour de la chambre (4) ou intégré dans le matériau de la paroi de la chambre.

5. Dispositif selon l'une des revendications précédentes, **caractérisé en ce que** le gaz ou le mélange de gaz s'écoule à travers la zone de chauffage d'un inducteur pour être chauffé.

6. Dispositif selon l'une des revendications précédentes, **caractérisé en ce qu'**une tête d'injection est constituée d'un matériau de type céramique résistant aux hautes températures, de préférence du nitrure de bore ou d'un mélange de composants en nitrure de bore et de composants en graphite et/ou les éléments de contact pour le/les matériau(x) en forme de bande et/ou de fil sont des éléments en cuivre refroidis à l'eau.

7. Dispositif selon l'une des revendications précédentes, **caractérisé en ce que** des canaux (6) sont formés avec la paroi de la chambre (4), à travers lesquels le matériau évaporé et encore à évaporer peut être guidé jusqu'à la sortie de l'ouverture (5) avec un trajet prolongé dans un temps augmenté.

8. Dispositif selon l'une des revendications précédentes, **caractérisé en ce que** deux matériaux en forme de bande ou de fil (2.1, 2.2) sont constitués d'au moins deux matériaux différentes et/ou est/sont un fil fourré.

9. Dispositif selon l'une des revendications précédentes, **caractérisé en ce que** la paroi de la chambre est constituée de graphite ou de graphite en combinaison avec un matériau de type céramique, plus particulièrement du nitrure de bore.

10. Dispositif selon l'une des revendications précédentes, **caractérisé en ce que** plusieurs ouvertures (5) existent sur une chambre (4).

11. Dispositif selon l'une des revendications précédentes, **caractérisé en ce que** plusieurs arcs électriques (2) sont formés sur des têtes d'injection dans une chambre (4) et/ou plusieurs chambres (4) sont reliées entre elles, plus particulièrement au moyen d'une chambre de pression allongée.

12. Dispositif selon l'une des revendications précédentes, **caractérisé en ce que** l'ouverture ou les ouvertures (5) de la chambre (4) et la buse de la tête d'injection présente/présentent au moins la température de fusion du matériau réfractaire.

13. Dispositif selon l'une des revendications précédentes, **caractérisé en ce que**, pour l'isolation de la chambre (4) à des températures > 2000 °C, une combinaison de laine de graphite pour la paroi de la chambre et d'inducteurs en cuivre refroidis à l'eau et entourés d'oxyde d'aluminium, est utilisée pour un chauffage à induction.

14. Dispositif selon l'une des revendications précédentes, **caractérisé en ce qu'**une ouverture (5) est réalisée sous la forme d'une buse se rétrécissant ou s'agrandissant de manière conique.

15. Procédé de réalisation de revêtements sur des surfaces d'un composant, d'un matériau en forme de bande ou d'un outil avec un dispositif selon l'une des revendications précédentes, **caractérisé en ce que** l'épaisseur et la composition d'un revêtement sont influencées par la quantité de matériau en forme de fil ou de bande (2.1, 2.2) introduit, de l'activation et de la désactivation d'un ou plusieurs arcs électriques (2) et/ou de chambres ou
la quantité du matériau évaporé par rapport à la quantité du matériau fondu est influencée, lors d'un processus de fusion à arc électrique, par le contrôle du débit volumique du flux de gaz et/ou
la distance entre la ou les surfaces à revêtir d'un matériau en forme de bande (7) et la surface de la chambre (4) est réglée, au moins au niveau de l'ouverture (5), au moyen de l'énergie cinétique du flux de vapeur-gaz sortant.
